(19) Europäisches Patentamt
European Patent Office
Office européen des brevets

(11) Numéro de publication : **0 022 416**
**B1**

(12) # FASCICULE DE BREVET EUROPÉEN

(45) Date de publication du fascicule du brevet : **13.07.83**

(51) Int. Cl.$^3$ : **H 01 L 21/322**, H 01 L 21/31, H 01 L 21/28

(21) Numéro de dépôt : **80401024.7**

(22) Date de dépôt : **04.07.80**

(54) **Procédé d'hydrogénation de dispositifs à semi-conducteurs.**

(30) Priorité : **06.07.79 FR 7917598**

(43) Date de publication de la demande : **14.01.81 Bulletin 81/02**

(45) Mention de la délivrance du brevet : **13.07.83 Bulletin 83/28**

(84) Etats contractants désignés : **CH DE GB IT LI NL**

(56) Documents cités :
**DE A 2 324 719**
**DE A 2 601 288**
**US A 4 113 514**

**IEEE JOURNAL OF SOLID-STATE CIRCUITS, vol. SC-13, no. 4, août 1978 NEW YORK (US) T.P. MA et al. : « Effects of RF annealing on the excess charge centers in MIS dielectrics », pages 445-454**

**JOURNAL OF THE ELECTROCHEMICAL SOCIETY, vol. 126, no. 6, juin 1979 PRINCETON (US) S. IWAMATSU et al. : « A method for reducing the hole and electron trapping densities in thermal SiO2 films », pages 1078-1080**

**IBM TECHNICAL DISCLOSURE BULLETIN, vol. 22, no. 8B, janvier 1980 NEW YORK (US) H. J. HOVEL : « Surface-interfacestate passivation », page 3879**

(73) Titulaire : **COMMISSARIAT A L'ENERGIE ATOMIQUE Etablissement de Caractère Scientifique Technique et Industriel**
**B.P. 510**
**F-75752 Paris Cedex 15 (FR)**

(72) Inventeur : **Chenevas-Paule, André**
**42, Rue de Stalingrad**
**F-38100 Grenoble (FR)**
Inventeur : **Le Goascoz, Vincent**
**Le Village du Rif No 39**
**F-38640 Claix (FR)**
Inventeur : **Viktorovitch, Pierre**
**1, rue des Poilus**
**F-38000 Grenoble (FR)**

(74) Mandataire : **Mongrédien, André et al**
**c/o BREVATOME 25, rue de Ponthieu**
**F-75008 Paris (FR)**

Il est rappelé que : Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

Jouve, 18, rue St-Denis, 75001 Paris, France

EP 0 022 416 B1

## Procédé d'hydrogénation de dispositifs à semi-conducteurs

L'invention concerne un procédé de passivation par hydrogénation de dispositifs à semi-conducteurs présentant des défauts de surface utilisant l'action de l'hydrogène atomique H° obtenu par création d'un plasma d'hydrogène au moyen d'un système capacitif.

Généralement, un dispositif à semi-conducteur est constitué par un matériau de base semi-conducteur, par exemple, du silicium monocristallin, dans lequel sont réalisées des diodes P + N ou N + P, l'ensemble étant, dans le cas des dispositifs à structure MIS (métal, isolant, semi-conducteur), recouvert par un isolant de grille. Le traitement thermique et la diffusion dans le silicium nécessaires à la réalisation des diodes entraînent l'apparition de défauts structuraux tels que des dislocations ou des défauts ponctuels ou de surface dans le semi-conducteur. De même, la réalisation d'un isolant de grille entraîne l'apparition de défauts à l'interface entre le semi-conducteur et cet isolant ainsi qu'à l'intérieur de la couche isolante. L'ensemble de ces défauts introduit dans le dispositif à semi-conducteur autant de niveaux localisés dans la bande interdite de celui-ci. Il en résulte notamment l'existence de transports parasites par sauts et des baisses importantes de la durée de vie des porteurs dans le semi-conducteur.

Afin de faire disparaître les défauts de volume, et notamment les défauts existant au niveau des jonctions des diodes P + N ou N + P, on a déjà proposé dans le brevet US-A-4 113 514 d'hydrogéner les dispositifs à semi-conducteurs, par exemple en faisant réagir chimiquement de l'hydrogène atomique H° avec les défauts du dispositif à semi-conducteur. L'hydrogène atomique H° peut en effet se lier chimiquement avec ces défauts en créant des liaisons covalentes ≡ Si − H, par exemple selon les deux réactions chimiques suivantes :

$$H° + \equiv Si \uparrow \rightarrow \equiv Si \uparrow\downarrow H \qquad (1)$$

$$2\,H° + \equiv Si \uparrow\downarrow Si \equiv \rightarrow 2 \equiv Si \uparrow\downarrow H \qquad (2)$$

Les niveaux liants et antiliants des liaisons covalentes ≡ Si − H ainsi obtenues se trouvent en effet respectivement dans la bande de valence et dans la bande de conduction, de sorte que les défauts localisés correspondants sont alors anihilés. En raison du très faible diamètre des atomes d'hydrogène monoatomique ($\nu \simeq 0{,}5$ Å), ceux-ci peuvent pénétrer dans le réseau du dispositif à semi-conducteur jusqu'à une certaine profondeur, par opposition à l'hydrogène moléculaire qui a de la peine à diffuser, de sorte que la suppression des défauts par un tel procédé n'est pas limitée aux défauts de surface, mais s'applique également aux défauts de volume, et notamment aux défauts situés au niveau des jonctions des diodes des dispositifs à semi-conducteurs.

Afin de mettre en œuvre efficacement un tel procédé, et en raison du caractère très instable et réactif de l'hydrogène atomique H°, il faut que l'hydrogène atomique soit créé très près des défauts que l'on souhaite anihiler. Pour cette raison, il est nécessaire de créer un plasma d'hydrogène dans lequel se forment continuellement des électrons e, des atomes H° et des ions $H^+$. A cet effet, on a proposé dans le brevet US-A-4 113 514 d'utiliser une décharge électroluminescente entretenue par un système de type self ou par couplage capacitif. Dans ce même brevet, on a aussi proposé de produire de l'hydrogène atomique par dissociation thermique de l'hydrogène moléculaire, cette dissociation pouvant notamment être obtenue soit au moyen d'un filament chaud, soit par bombardement électronique. Toutefois, la technique consistant à utiliser une décharge électroluminescente entretenue par un système capacitif est préférée à cette dernière méthode, car elle permet bien d'anihiler les défauts d'un dispositif à semi-conducteur placé dans l'enceinte, notamment au niveau des jonctions des diodes. Cependant, en raison de la géométrie du système du type self, les ions $H^+$ tournent dans le champ magnétique induit par le bobinage ou par l'antenne radiofréquence RF. Ce mouvement des ions $H^+$ est défavorable au but poursuivi, car il en résulte que les ions $H^+$ peuvent atteindre et bombarder la surface du dispositif à semi-conducteur dont ils peuvent endommager le réseau sur des profondeurs relativement importantes pouvant aller par exemple jusqu'à 100 Å et plus. L'analyse des courbes apparaissant à la figure 2 du brevet US-A-4 113 514, confirme ces deux effets des systèmes du type self. Ainsi, ces courbes montrent une augmentation du courant à faible tension résultant du régime ohmique dû au bombardement de surface, et une amélioration de la conduction de volume à forte tension. L'utilisation des dispositifs du type self connus conduit donc, simultanément à la suppression des défauts au niveau des jonctions des diodes par réaction chimique de l'hydrogène atomique avec ces défauts et à la création de nouveaux défauts dus au bombardement du dispositif à semi-conducteur par les ions $H^+$ qui se trouvent dans le plasma d'hydrogène avec l'hydrogène atomique H°.

La présente invention a pour objet un procédé de passivation par hydrogénation de dispositifs à semi-conducteurs permettant de faire disparaître par hydrogénation les défauts de volume, et d'interface, par exemple au niveau des jonctions des diodes contenues dans ces dispositifs, ou au niveau des interfaces isolant-silicium, tout en évitant la création de défauts dus au bombardement du dispositif à semi-conducteur par les ions $H^+$ contenus dans le plasma.

Dans ce but, il est proposé un procédé de passivation par hydrogénation de dispositifs à semi-conducteurs, du type suivant lequel on crée un plasma d'hydrogène au moyen d'un système capacitif, caractérisé en ce que l'on applique au

dispositif semi-conducteur une polarisation apte à éloigner de sa surface les ions $H^+$ contenus dans ledit plasma.

Un procédé particulier selon l'invention consiste à disposer le dispositif à semi-conducteur entre les électrodes du système capacitif, au niveau de l'anode.

Grâce à un procédé de ce type, les ions $H^+$ contenus dans le plasma sont accélérés vers la cathode, c'est-à-dire à l'opposé du dispositif à semi-conducteur disposé au niveau de l'anode, de telle sorte que les ions $H^+$ ne bombardent pas le dispositif comme dans les procédés antérieurs utilisant un système à self. Au contraire, les électrons $e^-$ sont dirigés vers le dispositif à semi-conducteur, mais leur action sur ce dernier est négligeable.

L'invention peut d'ailleurs être perfectionnée par l'utilisation de moyens aptes à éloigner les électrons du semi-conducteur.

Conformément à une caractéristique préférée de l'invention, on chauffe le dispositif à semi-conducteur à une température comprise entre 25 °C et 500 °C pendant la création du plasma, afin de favoriser la réaction de l'hydrogène monoatomique H° avec les défauts.

Conformément à une caractéristique secondaire de l'invention, le système capacitif est placé sous un vide compris entre 13 pa et 1,3 pa. De préférence, la valeur de la pression est alors déterminée par la valeur du débit d'hydrogène pendant la création du plasma.

Selon une première variante de l'invention, les électrodes sont soumises à une tension continue voisine de 2 KV.

Selon une seconde variante, les électrodes sont soumises à une tension alternative comprise entre 1,2 et 1,6 KV crête à crête et dont la fréquence est voisine de 13 MHz.

On décrira maintenant, à titre d'exemple non limitatif, un mode de réalisation particulier de l'invention en se référant au dessin annexé dans lequel la figure unique représente de façon schématique un appareil pour le traitement par hydrogénation de dispositifs à semi-conducteurs présentant des défauts tels que des dislocations.

L'appareil représenté sur la figure comprend une enceinte étanche 10 reliée à un système de pompage (non représenté) par un ou plusieurs conduits 12. L'enceinte 10 contient deux électrodes 14 et 16 polarisées de façon appropriée afin de constituer respectivement une cathode et une anode. Conformément à l'invention, les électrodes 14 et 16 sont planes et parallèles de façon à définir un système capacitif. A titre d'exemple, le diamètre des électrodes 14 et 16 peut être d'environ 100 mm.

Afin de favoriser la réaction chimique de l'hydrogène atomique avec les défauts du dispositif à semi-conducteur à traiter, un dispositif de chauffage 18 tel qu'un four est disposé à proximité de l'anode 16 sur laquelle est fixé le dispositif à semi-conducteur 20, entre les électrodes 14 et 16.

L'appareil de traitement qui vient d'être décrit en se référant à la figure unique fonctionne de la façon suivante.

Initialement, on établit à l'intérieur de l'enceinte 10 un vide d'environ $10^{-5}$ pa. L'hydrogène introduit dans l'enceinte 10 ramène la pression entre 13 et 1,3 pa et il est alors décomposé en appliquant une tension appropriée entre les électrodes 14 et 16. Selon une première variante, la tension ainsi appliquée est une tension continue, de préférence voisine de 2 KV. Selon une deuxième variante, la tension établie entre les électrodes 14 et 16 est une tension alternative haute fréquence dont la valeur est comprise entre 1,2 et 1,6 KV crête à crête et dont la fréquence, située dans le domaine des radiofréquences RF, est voisine de 13 MHz (par exemple 13,56 MHz).

Sous l'effet de la tension appliquée entre les électrodes 14 et 16, l'hydrogène contenu dans l'enceinte 10 est excité sous décharge électroluminescente et se transforme en un plasma luminescent 22, à l'exception d'une zone sombre 24, dite zone de Crookes, qui se crée près de la cathode 14. Le plasma 22 contient de l'hydrogène monoatomique H° neutre, des ions $H^+$ et des électrons $e^-$. La pression régnant dans l'enceinte 10 est réglée en fonction du débit d'hydrogène pour atteindre par exemple une valeur de 2 × 13 pa en l'absence de décharge et de 5 × 1,3 pa en présence de décharge.

La constitution du plasma 22 est la même quelle que soit la nature de la tension appliquée aux électrodes 14 et 16, bien que les électrons $e^-$ suivent la haute fréquence lorsque cette tension est une tension alternative. Dans tous les cas, les ions $H^+$ sont donc accélérés vers la cathode 14 et les électrons $e^-$ vers le dispositif à semi-conducteur 20 comme l'illustre la figure. Au contraire, l'hydrogène monoatomique H° neutre est insensible au champ électrique. Dans tout le volume du plasma 22, et donc tout près du dispositif à semi-conducteur 20, des atomes d'hydrogène H° sont sans cesse créés et anihilés selon les deux réactions suivantes :

$$H^+ + e^- \rightarrow H^\circ \quad (3)$$

$$H^\circ + H^\circ \rightarrow H_2 \quad (4)$$

En raison de leur faible diamètre, les atomes d'hydrogène H° ainsi créés peuvent pénétrer dans le réseau de semi-conducteur 20 et réagir avec différents défauts de ce dernier selon les réactions (1) et (2) déjà mentionnées.

Les défauts localisés correspondants sont ainsi anihilés. Pour faciliter cette opération, simultanément à la création du plasma, il est nécessaire de chauffer le dispositif à semi-conducteur 20 au moyen du four 18 jusqu'à une température choisie en fonction de la nature du semi-conducteur traité, cette température étant généralement située entre 25 °C et 500 °C.

Grâce à la forme et à la disposition relatives des électrodes 14 et 16 et grâce à la disposition du dispositif à semi-conducteur 20 au niveau de l'anode 16, les ions $H^+$ créés dans le plasma sont

accélérés vers la cathode 14 en éloignement du dispositif 20 et ne bombardent pas ce dispositif. Il en résulte que les protons créés dans le plasma d'hydrogène ne créent pas de défauts dans le dispositif 20. Bien que les électrons créés dans le plasma bombardent le dispositif à semi-conducteur 20, l'effet de ce bombardement peut être considéré comme négligeable en raison de leur masse très réduite.

On peut d'ailleurs envisager de le diminuer, ou de le supprimer en appliquant des moyens aptes à éloigner les électrons du dispositif 20, notamment un champ magnétique.

Il va de soi que le procédé de traitement et l'appareil pour la mise en œuvre de ce procédé qui viennent d'être décrits, peuvent être utilisés pour traiter des dispositifs à semi-conducteurs de différents types, pourvu que ces dispositifs présentent des liaisons pendantes en surface et des défauts en volume, permettant à l'hydrogène monoatomique créé dans le plasma de réagir avec les défauts correspondants.

Par ailleurs, l'invention n'est pas limitée à la mise en œuvre d'un appareil de type dit « capacitif » ; tout appareil permettant de créer un plasma d'hydrogène et d'éloigner du dispositif à traiter les ions $H^+$ produits (notamment par polarisation des dispositifs par rapport au plasma) convient.

**Revendications**

1. Procédé de passivation par hydrogénation de dispositifs à semi-conducteurs, du type suivant lequel on crée un plasma d'hydrogène au moyen d'un système capacitif, caractérisé en ce que l'on applique au dispositif semi-conducteur une polarisation apte à éloigner de sa surface les ions $H^+$ contenus dans ledit plasma.

2. Procédé selon la revendication 1, caractérisé en ce qu'il consiste à disposer le dispositif semi-conducteur entre les électrodes planes et parallèles du système capacitif, au niveau de l'anode.

3. Procédé selon l'une quelconque des revendications 1 ou 2, caractérisé en ce qu'on chauffe le dispositif à semi-conducteur à une température comprise entre 25 °C et 500 °C pendant la création du plasma.

4. Procédé selon l'une quelconque des revendications 1 à 3, caractérisé en ce que le système est placé sous un vide compris entre 13 pa et 1,3 pa.

5. Procédé selon la revendication 4, caractérisé en ce que la valeur de la pression est déterminée par la valeur du débit d'hydrogène pendant la création du plasma.

6. Procédé selon l'une quelconque des revendications 2 à 5, caractérisé en ce que les électrodes sont soumises à une tension continue voisine de 2 KV.

7. Procédé selon l'une quelconque des revendications 2 à 5, caractérisé en ce que les électrodes sont soumises à une tension alternative comprise entre 1,2 et 1,6 KV crête à crête et dont la fréquence est voisine de 13 MHz.

**Claims**

1. Hydrogenation passivation process for semiconductor devices of the type in which a hydrogen plasma is formed in a capacitor system, characterized in that the semiconductor device is exposed to a polarization adapted to keep $H^+$ ions contained in said plasma away from its surface.

2. Process according to Claim 1, characterized in that the semiconductor device is positioned between flat parallel electrodes of the capacitor system, at the level of the anode.

3. Process according to either of Claims 1 and 2, characterized in that the semiconductor device is heated to a temperature between 25 and 500 °C during formation of the plasma.

4. Process according to any one of Claims 1 to 3, characterized in that the system is placed under a vacuum of 13 pa to 1.3 pa.

5. Process according to Claim 4, characterized in that the value of the pressure is determined by the hydrogen flow rate during formation of the plasma.

6. Process according to any one of Claims 2 to 5, characterized in that the electrodes are subjected to a continuous potential of around 2KV.

7. Process according to any one of Claims 2 to 5, characterized in that the electrodes are subjected to an alternating potential of between 1.2 and 1.6 KV, peak to peak whose frequency is around 13 MHz.

**Ansprüche**

1. Verfahren zur Passivierung von Halbleitereinrichtungen durch Hydrierung von der Art, bei der ein Wasserstoffplasma mittels eines kapazitiven Systems erzeugt wird, dadurch gekennzeichnet, daß an die Halbleitereinrichtung eine Polarisation angelegt wird, welche geeignet ist, von ihrer Oberfläche die $H^+$-Ionen zu entfernen, die in dem Plasma enthalten sind.

2. Verfahren nach Anspruch 1, dadurch gekennzeichnet, daß die Halbleitereinrichtung zwischen den ebenen und parallelen Elektroden des kapazitiven Systems auf der Höhe der Anode angeordnet wird.

3. Verfahren nach Anspruch 1 oder 2, dadurch gekennzeichnet, daß die Halbleitereinrichtung auf eine Temperatur zwischen 25 °C und 500 °C während der Erzeugung des Plasmas erwärmt wird.

4. Verfahren nach einem der Ansprüche 1 bis 3, dadurch gekennzeichnet, daß sich das System in einem Vakuum zwischen 13 pa und 1,3 pa befindet.

5. Verfahren nach Anspruch 4, dadurch gekennzeichnet, daß der Wert des Druckes durch den Wert der Strömungsmenge des Wasserstoffes während der Erzeugung des Plasmas bestimmt wird.

6. Verfahren nach einem der Ansprüche 2 bis 5, dadurch gekennzeichnet, daß an die Elektroden eine Gleichspannung von ungefähr 2 KV angelegt

wird.

7. Verfahren nach einem der Ansprüche 2 bis 5, dadurch gekennzeichnet, daß an die Elektroden eine Wechselspannung zwischen 1,2 und 1,6 KV von Spitze zu Spitze und mit einer Frequenz von ungefähr 13 MHz angelegt wird.

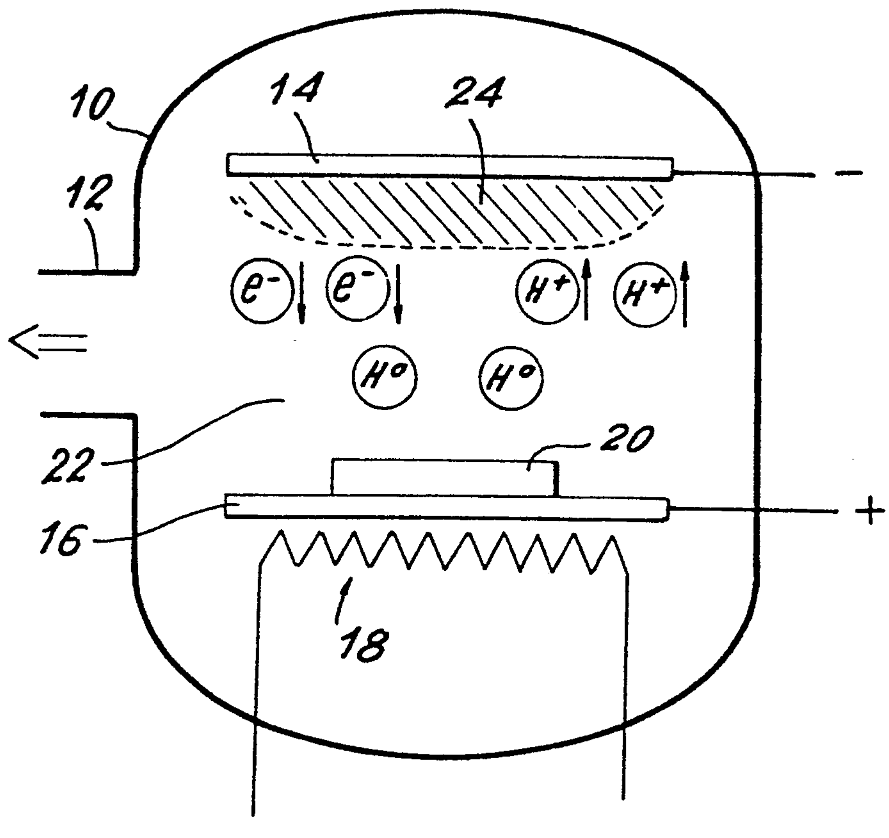
10
14
24
12
−
e⁻
e⁻
H+
H+
H°
H°
20
22
+
16
18